# EUROPEAN PATENT APPLICATION

(11) **EP 1 936 685 A2**
(43) Date of publication of application: **25.06.2008**
(21) Application number: 07024822.4
(22) Date of filing: 20.12.2007
(51) Int. Cl.: H01L 23/427

(54) **Semiconductor device**

(30) Priority: 20.12.2006 JP 2006343227
(71) Applicant: SHINKO ELECTRIC INDUSTRIES CO., LTD., Nagano-shi, Nagano 381-2287 (JP)
(72) Inventor: Koizumi, Naoyuki, Nagano-shi, Nagano, 381-2287 (JP)
(74) Representative: Zimmermann, Gerd Heinrich

(57) **Abstract**

A semiconductor device having a semiconductor chip 101 in which an electrode pad 102 is formed on the side of a device surface, and an interposer 201 in which flip-chip mounting of the semiconductor chip is performed by the electrode pad, wherein a flow path 203, 203A for circulating a refrigerant for cooling the semiconductor chip is formed in the interposer.

## Description

The present invention relates to a semiconductor device on which a semiconductor chip is mounted, in particular to a cooled semiconductor device and a mother board with a semiconductor device.

A calorific power per unit area of a semiconductor chip tends to increase with an increase in performance of the semiconductor chip in recent years. For example, in a high-performance semiconductor chip with high operating speed, a permittivity material (so-called Low-k material) with small wiring delay (parasitic capacitance) tends to be used as a material of an interlayer dielectric used in a wiring layer.

The low permittivity material has thermal conductivity lower than that of a conventional interlayer insulating film (for example, a silicon oxide film), and heat dissipation of the semiconductor chip tends to become more difficult. As a result of this, a high-performance semiconductor device has fears that a malfunction in a circuit of the semiconductor chip due to heat or deterioration in the semiconductor chip due to heat occurs.

A method for cooling a semiconductor chip by water cooling or air cooling using, for example, a cooling fan has been proposed conventionally (for example, see Japanese Patent Unexamined Publications JP-A-2001-308470 and JP-A-2006-148117).

However, in a recent high-performance semiconductor chip, there is the semiconductor chip whose calorific power exceeds 100 W/cm², and conventional cooling method and cooling structure have a fear that the cooling capacity runs short.

For example,theinventionsdisclosedin JP-A-2001-308470 and JP-A-2006-148117 described above have a structure in which a semiconductor chip is cooled from a back surface (a surface opposite to a surface on which electric circuit is formed) of the semiconductor chip, and it became difficult to increase the cooling capacity of a device resulting in a heat generation source.

Also, the inventions disclosed in JP-A-2001-308470 and JP-A-2006-148117 described above have a structure in which a semiconductor chip makes contact with a cooling structure through predetermined resin material or adhesive material. For example, due to the original property of such material, there is a limit to which thermal conductivity of the resin material or the adhesive material is increased. Thus, low thermal conductivity of the resin material or the adhesive material becomes a problem in increasing the cooling capacity (cooling efficiency).

In addition, when the semiconductor chip makes contact with the cooling structure through the resin material or the adhesive material, plural interfaces with which a different material makes contact are present between the cooling structure and the semiconductor chip. As a result of this, thermal resistance at the interfaces increases and the thermal resistance at these interfaces became a problem in increasing the cooling capacity.

In view of the above the invention is to provide a new and useful semiconductor device for solving the problems described above.
A semiconductor device according to independent claim 1, and a mother board according to claim 12 are provided.
Further advantages, features, aspects and details are evident from the dependent claims, the description and the drawings.

A concrete problem of the invention is to improve cooling efficiency of a semiconductor device on which a semiconductor chip is provided.

According to an aspect of the invention, there is provided a semiconductor device including:
a semiconductor chip on which an electrode pad is formed; and
an interposer to which the semiconductor chip is flip-chip bonded via the electrode pad,
wherein a flow path for circulating refrigerant for cooling the semiconductor chip is formed in the interposer.

According to the invention, cooling efficiency of a semiconductor device on which a semiconductor chip is provided can be improved.

So that the manner in which the above recited features of the present invention can be understood in detail, a more particular description of the invention, briefly summarized above, may be had by reference to embodiments. The accompanying drawings relate to embodiments of the invention and are described in the following:

Fig. 1 is a diagram showing a semiconductor device according to a first embodiment;
Fig. 2 is a first configuration example of a flow path of the semiconductor device of Fig. 1;
Fig. 3 is a second configuration example of a flow path of the semiconductor device of Fig. 1;
Fig. 4 is a diagram showing a semiconductor device according to a second embodiment;
Fig. 5 is a diagram showing a semiconductor device according to a third embodiment;
Fig. 6 is a diagram showing a semiconductor device according to a fourth embodiment;
Fig. 7 is a diagram showing a semiconductor device according to a fifth embodiment;
Fig. 8 is a diagram showing a semiconductor device according to a sixth embodiment;
Fig. 9 is a diagram showing a mother board according to a seventh embodiment; and
Fig. 10 is a diagram showing a semiconductor device including laminated semiconductor chips.

A semiconductor device according to the invention has a semiconductor chip on which an electrode pad is formed, and an interposer which is flip-chip bonded to the semiconductor chip via the electrode pad, and a flow path for circulating a refrigerant for cooling the semiconductor chip is formed in the interposer.

In the semiconductor device described above, the flow path is directly formed in the interposer, the cooling efficiency of the semiconductor device is improved. Especially, since the electrode pad of which property is high in thermal conductivity connects the semiconductor chip with the interposer, and the heat generated in the semiconductor chip is transferred to the interposer via the electrode pad, and the transferred heat is cooled effectively by the flow path formed in the interposer. Therefore, the cooling efficiency of the semiconductor device is improved.

In addition, in the structure described above, a path of electrical connection for mounting of the semiconductor chip is used as a path of heat transfer for cooling the semiconductor chip. As a result of this, a special adhesive or resin material for connecting a cooling structure to the semiconductor chip is not required and a structure of the semiconductor device is simplified and also cooling efficiency improves.

Next, a further concrete configuration example of the semiconductor device will hereinafter be described based on the drawings.

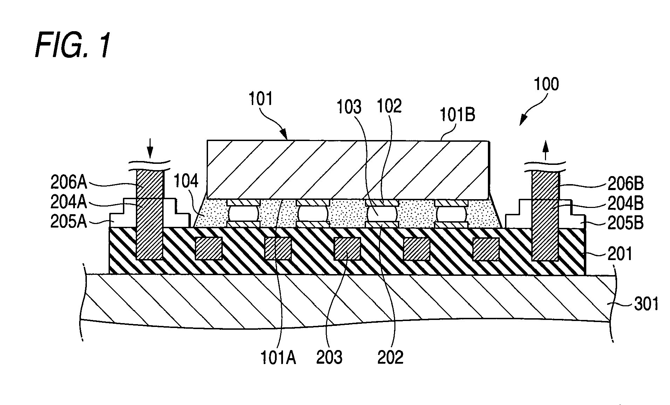

Fig. 1 is a sectional diagram schematically showing a semiconductor device 100 according to a first embodiment of the invention. Referring to Fig. 1, an outline of the semiconductor device 100 according to the present embodiment has a structure in which a semiconductor chip 101 is flip-chip bonded to an interposer 201.

The semiconductor chip 101 has a device surface 101A on which an electronic circuit (not shown) such as a logic circuit is formed, and a back surface 101B opposite to the device surface 101A.

An electrode pad 102 formed on the device surface 101A of the semiconductor chip is connected to a conductive pattern (wiring pattern) 202 formed on the side facing the semiconductor chip 101 of the interposer 201 via, for example, a bump 103. In addition, an under fill 104 using a resin material as a main component is infiltrated an area defined between the semiconductor chip 101 and the interposer 201.

Further, the interposer 201 is joined (bonded) on a predetermined substrate 301, and the conductive pattern 202 is constructed so as to be connected to a conductive pattern (not shown) on the substrate 301 via, for example, a bonding wire (not shown) etc.

In the semiconductor device 100 according to the embodiment, a flow path 203 for circulating refrigerant for cooling the mounted semiconductor chip 101 is formed inside the interposer 201. The refrigerant made of liquid such as water alcohol, or fluorine based liquid is circulated through the flow path 203 and the interposer 201 is cooled, further, the semiconductor chip 101 is also cooled through the interposer 201.

A supply port 204A for supplying the refrigerant to the flow path 203 and a discharge port 204B for discharging the refrigerant from the flow path 203 are formed in a surface in which the semiconductor chip 101 of the interposer 201 is mounted. Further, supply piping 206A is connected to the supply port 204A through a connection component (joint component) 205A. Similarly, discharge piping 206B is connected to the discharge port 204B through a connection component (joint component) 205B.

In the construction described above, refrigerant supplied from the supply piping 206A is supplied to the flow path 203 through the supply port 204A and heat exchange (cooling) is performed between the interposer 201 and the refrigerant. Further, the refrigerant after the heat exchange is constructed so as to be discharged from the discharge piping 206B through the discharge port 204B.

In the semiconductor device 100 according to the embodiment, the semiconductor chip 101 can be cooled from the side of the device surface 101A and thus cooling efficiency of the semiconductor chip 101 improves.

A structure in which a semiconductor chip is cooled from a back surface (the side opposite to a device surface) of the semiconductor chip as shown in the invention described in, for example, JP-A-2001-308470 or JP-A-2006-148117 became major conventionally. This raises a problem in improving cooling efficiency of the semiconductor chip.

Heat generation of a semiconductor chip is mainly generated in the side of a device surface in which a logic circuit etc. or multilayer wiring connected to the logic circuit etc. is formed, and it became difficult to form a cooling structure directly on the device surface or bring a cooling structure into direct contact with the device surface in structure. As a result of this, in the conventional semiconductor device, the semiconductor chip must be cooled from the back surface side and it became a problem in improving cooling efficiency.

On the other hand, in the semiconductor device 100 according to the embodiment, the semiconductor chip 101 is mounted on the interposer 201 cooled by the flow path 203 by the electrode pad 102.

That is, flip-chip connection of the semiconductor chip 101 is made so that the device surface 101A corresponds to the interposer 201 cooled by the flow path 203. As a result of this, heat generation by the semiconductor chip 101 is cooled by the interposer 201 through the electrode pad 102.

In addition, according to the present invention, although the device surface 101A is formed on the back surface of the semiconductor device, since the electrode pad of which property is high in heat conductivity connects the semiconductor chip with the interposer, the generated heat in the semiconductor chip is transferred to the interposer via the electrode pad, the cooling efficiency is improved.

Therefore, the device formed in the chip, resulting in a main heat generation source of the semiconductor chip 101, can be cooled efficiently.

Also, the semiconductor chip can be cooled more efficiently by forming the flow path 203 just below a place (hot spot) in which a calorific power is particularly large in the device surface 101A of the semiconductor chip.

Also, according to the invention, a part of the path of heat transfer for cooling the semiconductor chip 101 shares electrical connection for mounting between the semiconductor chip 101 and the interposer 201. That is, a path through the electrode pad 102, the bump 103 and the conductive pattern 202 used in the electrical connection (mounting) of the semiconductor chip is used as a path of heat transfer of the semiconductor chip 101. As a result of this, a resin material or an adhesive for connecting a cooling structure to the semiconductor chip is not required and a structure of the semiconductor device is simplified and also cooling efficiency improves.

In the structure described above, the heat transfer path of the semiconductor chip partially shares the electrical connection path of the semiconductor chip, so that the heat transfer path is mainly constructed of a metallic material. The electrode pad 102 is made of a metallic material such as Al or Cu. Also, a layer (of Ni, Au, etc.) for improving electrical connection may be formed on the electrode pad. Also, the bump 103 is made of, for example, solder or Au. The bump 103 can be formed by melting a solder ball and may also be formed by wire bonding using a bonding wire made of Au. Also, the conductive pattern 202 is formed by, for example, Cu. A layer (of Ni, Au, etc.) for improving electrical connection may be formed on the conductive pattern 202.

Since the heat transfer path (the electrode pad 102, the bump 103, the conductive pattern 202, etc.) is formed using a material (mainly, metal) used in electrical connection thus, thermal conductivity is high and cooling efficiency of the semiconductor chip improves.

Also, the electrode pad 102 is constructed so as to be connected to a device (not shown), resulting in a main heat generation source, formed in the semiconductor chip 101. The electrode pad 102 is connected to the device by a wiring structure (multilayer wiring structure, not shown) using a metallic material (for example, Cu) with high thermal conductivity as a main component. As a result of this, the semiconductor device 100 according to the embodiment has a suitable structure in the case of efficiently cooling the device (logic circuit etc.) becoming a main cause of heat radiation.

Also, in the construction described above, it may be constructed so that thermal conductivity of the under fill 104 inserted between the semiconductor chip 101 and the interposer 201 is increased and cooling efficiency of the semiconductor chip 101 improves more.

Fine particles called a filler for adjusting hardness of a resin material are generally mixed (added) into the under fill 104. A material using, for example, SiO₂ called silica as a main component is widely used as the filler. In place of using the silica, for example, by using a high thermal conductivity material (for example, higher than thermal conductivity of the resin material of an added target), thermal conductivity of the under fill is increased and cooling efficiency of the semiconductor chip 101 can be improved.

For example, a metallic material such as Au, Ag, Cu, Al, Ni, Cr or Co with high thermal conductivity can be used as the filler. However, there is a fear that the adjacent electrical connection part (the electrode pad 102, the bump 103, the conductive pattern 202, etc.) is energized depending on an additive rate to the resin material when the metallic material is used as the filler.

Considering that, it is preferable to use a material whose surface is covered with an insulating material (for example, a resin material) when the filler made of the metallic material is used. In this case, while preventing energization of the adjacent electrical connection part, thermal conductivity of the filler 104 can be enhanced to improve cooling efficiency of the semiconductor chip 101.

Also, a filler made of, for example, Al₂O₃ (alumina) or AlN (aluminum nitride) in addition to the materials described above can be used.

Also, the interposer 201 can be constructed using various materials such as a metallic material (for example, silicon, glass or ceramic) whose surface is insulated (covered with an insulating material). Among the materials, silicon which is the same as a main material constructing the semiconductor chip 101 is particularly preferable. When the interposer 201 is constructed of silicon, a difference between the interposer 201 and the semiconductor chip 101 in a coefficient of thermal expansion becomes small. Therefore, fears of failure or a break in wire of the portion of connection between the semiconductor chip 101 and the interposer 201 reduce and reliability of mounting improves.

Also, on silicon, micro fabrication can be performed and the silicon has thermal conductivity higher than that of ceramic or glass and cooling efficiency of the semiconductor chip improves, so that it is preferable.

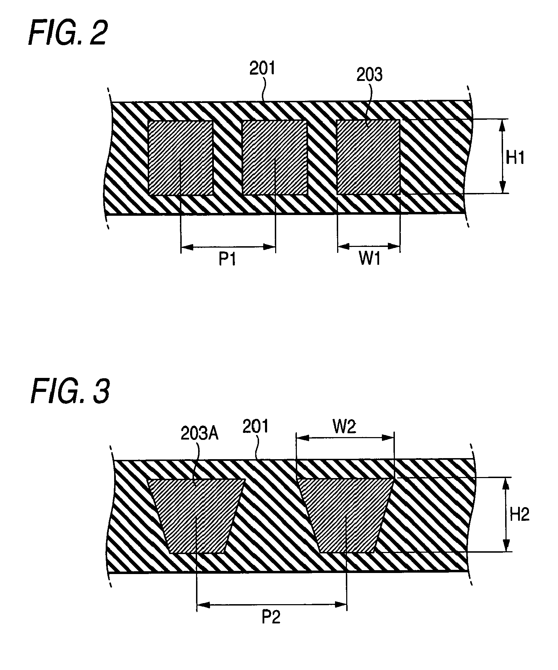

Also, Fig. 2 is an enlarged diagram (sectional diagram) showing a first example of a configuration in the case of forming the flow path 203 with a sectional shape of a rectangle (square) in the interposer 201. For example, when the interposer 201 is made of silicon, the flow path 203 is formed so that the width W1 is 40 to 500 µm and the height H1 is 50 to 300 µm and the pitch P1 between the adjacent flow paths is about 50 to 1000 µm.

Also, Fig. 3 is an enlarged diagram (sectional diagram) showing a second example of a configuration in the case of forming a flow path 203A with a sectional shape of a trapezoid in the interposer 201. For example, when the interposer 201 is made of silicon, the flow path 203A is formed so that the width (long side) W2 is 40 to 500 µm and the height H2 is 30 to 300 µm and the pitch P1 between the adjacent flow paths is about 50 to 2000 µm.

In addition, the numerical values described above are just one example and the invention is not limited to these numerical values. Also, the sectional shape of the flow path is not limited to the shapes described above and may be modified and changed in various shapes. Also, for example, it may be constructed so that a structural body for controlling a flow inside the flow path 203 (203A) of refrigerant is disposed inside the flow path or surface treatment is performed on the flow path and the Reynolds number of the refrigerant is controlled as necessary and cooling (heat exchange) efficiency improves.

Also, the invention is not limited to the structures described above and, for example, the following semiconductor device may be constructed.

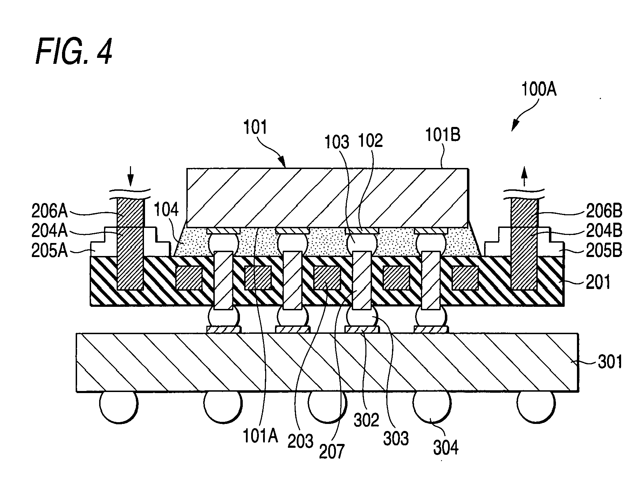

Fig. 4 is a sectional diagram schematically showing a semiconductor device 100A according to a second embodiment of the invention. However, in the following diagram, the same numerals are assigned to the portions described above and the description may be omitted (similar matters apply to the following embodiments).

The semiconductor device 100A of the second embodiment differs from the semiconductor device 100 of the first embodiment in the following respect. Also, the portion which is not particularly described shall have a structure similar to that of the semiconductor device 100 shown in the first embodiment (Fig. 1).

Referring to Fig. 4, the semiconductor device 100A according to the embodiment is characterized by having plural penetrating electrodes 207 extending through an interposer 201. Also, a semiconductor chip 101 is connected to the penetrating electrodes 207 penetrating electrode pads 102 and bumps 103.

Further, the semiconductor device 100A according to the embodiment has the interposer 201 and a laminated substrate 301 (on which the interposer 201 is provided). A conductive pattern 302 made of, for example, Cu is formed on the side facing the interposer 201 of the substrate 301. Also, the penetrating electrode 207 is connected to the conductive pattern 302 through a bump 303. Also, an external connection terminal made of, for example, a solder bump is formed on the side opposite to the side on which the conductive pattern 302 of the substrate 301 is formed. Further, the external connection terminal 304 is constructed so as to be electrically connected to the conductive pattern 302 by a wiring structure (may be, for example, multilayer wiring) which is omitted in the diagram.

The penetrating electrode 207 is formed by, for example, Cu. The conductive pattern 302 is formed by, for example, Cu. A layer (of Ni, Au, etc.) for improving electrical connection may be formed on the conductive pattern 302. Also, the bump 303 is made of, for example, solder or Au. The bump 303 can be formed by melting a solder ball and may also be formed by wire bonding using a bonding wire made of Au.

In the semiconductor device 100A according to the embodiment, cooling efficiency of the semiconductor chip 101 improves more than the case of the first embodiment since the penetrating electrode 207 connected to the semiconductor chip 101 (electrode pad 102) extends through the interposer 201 cooled by a flow path.

Also, when a flow path 203 includes the portion formed between the penetrating electrodes 207 in the structure described above, cooling efficiency of the semiconductor chip 101 improves more and it is preferable. For example, when the flow path 203 is formed so as to pass between each of the plural penetrating electrodes 207 formed, heat exchange by the refrigerant is performed in the vicinity of the plural penetrating electrodes 207, so that the penetrating electrodes 207 (semiconductor chip 101) can be cooled efficiently.

Also, the semiconductor device 100A according to the embodiment facilitates miniaturization of the semiconductor device as compared with the case of connecting the interposer 201 to the substrate 301 by, for example, a bonding wire.

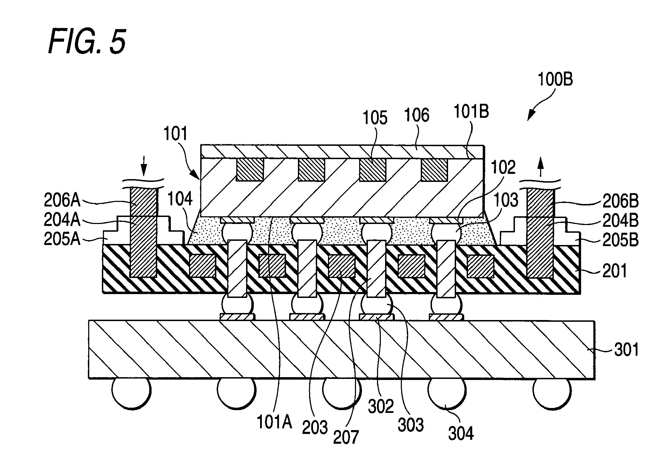

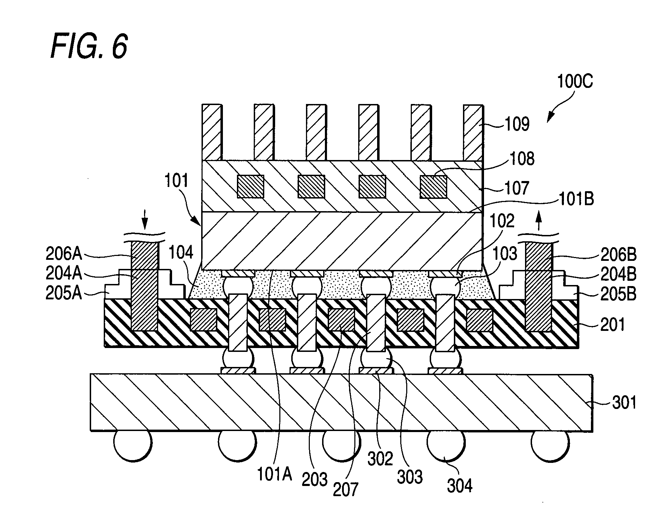

Also, a flow path for circulating the refrigerant for cooling the semiconductor chip 101 may be disposed in, for example, the side opposite to the side connected to the interposer 201 of the semiconductor chip 101 as well as the inside of the interposer 201 (an upper layer flow path). Also in this case, the flowpath (upper layer flowpath) maybe disposed in the semiconductor chip 101 as described below in Fig. 5, and may also be disposed in a cooling plate joined to a back surface of a semiconductor chip as described below in Fig. 6.

Fig. 5 is a sectional diagram schematically showing a semiconductor device 100B according to a third embodiment of the invention. The semiconductor device 100B according to the present embodiment differs from the semiconductor device 100A according to the second embodiment (Fig. 4) in the following respect. Also, the portion which is not particularly described shall have a structure similar to that of the semiconductor device 100A shown in the second embodiment.

Referring to Fig. 5, in the semiconductor device 100B according to the embodiment, a flow path (upper layer flow path) 105 for circulating the refrigerant is formed in the side (the side opposite to a device surface 101A) of a back surface 101B of a semiconductor chip 101. Also, the flow path 105 is constructed so as to close a channel-shaped opening by a lid part 106 joined to the semiconductor chip 101.

In the semiconductor device 100B according to the embodiment, the semiconductor chip 101 is cooled from the side of the device surface 101A by an interposer 201 and also is cooled from the side of the back surface 101B by the flow path 105. As a result of this, the cooling capacity of the semiconductor chip 101 increases more.

Also, Fig. 6 is a sectional diagram schematically showing a semiconductor device 100C according to a fourth embodiment of the invention. The semiconductor device 100C according to the present embodiment differs from the semiconductor device 100A according to the second embodiment in the following respect. Also, the portion which is not particularly described shall have a structure similar to that of the semiconductor device 100A shown in the second embodiment (Fig. 4).

Referring to Fig. 6, in the semiconductor device 100C according to the embodiment, a cooling plate 107 in which a flow path (upper layer flow path) 108 for circulating the refrigerant is formed is joined to the side (the side opposite to a device surface 101A) of a back surface 101B of a semiconductor chip 101. Also, plural heat sinks 109 for improving cooling efficiency by air cooling are installed on the cooling plate 107.

In the semiconductor device 100C according to the embodiment, the semiconductor chip 101 is cooled from the side of the device surface 101A by an interposer 201 and also is cooled from the side of the back surface 101B by the flow path 108 (cooling plate 107). As a result of this, the cooling capacity of the semiconductor chip 101 increases more.

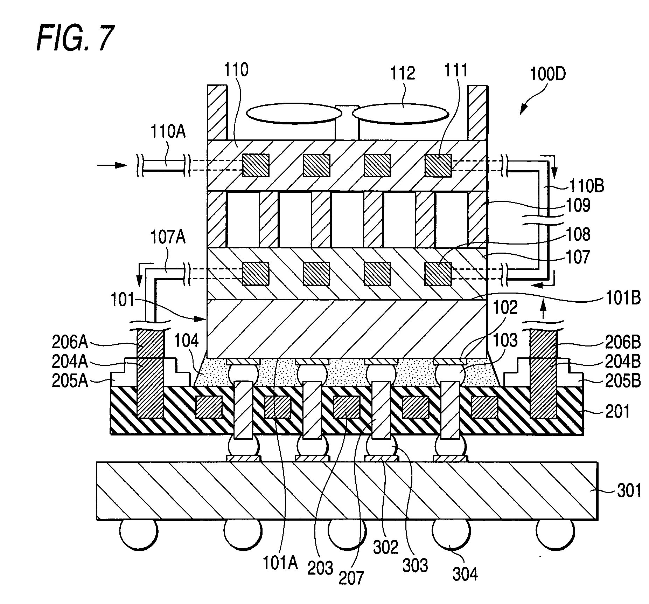

Also, Fig. 7 is a sectional diagram schematically showing a semiconductor device 100D according to a fifth embodiment of the invention. The semiconductor device 100D of the fifth embodiment differs from the semiconductor device 100C of the fourth embodiment in the following respect. Also, the portion which is not particularly described shall have a structure similar to that of the semiconductor device 100C shown in the fourth embodiment (Fig. 6).

Referring to Fig. 7, in the semiconductor device 100D according to the embodiment, another cooling plate 110 is laminated on a cooling plate 107 through heat sinks 109. A flowpath (top layer flowpath) 111 for circulating a refrigerant is formed inside the cooling plate 110.

That is, the semiconductor device 100D according to the embodiment is constructed so as to laminate the cooling plate 107 in which a flow path (upper layer flow path) 108 is formed and the cooling plate 110 in which the flow path (top layer flow path) 111 is formed through the heat sinks 109. Also, an air cooling fan 112 for improving cooling efficiency by air cooling is further installed on the cooling plate 110.

By installing the cooling plate 110 and the air cooling fan 112, the cooling capacity of a semiconductor chip 101 increases more than the semiconductor device 100C according to the fourth embodiment in the semiconductor device 100D according to the embodiment.

Also, in the case of supplying (circulating) refrigerant to the flow paths 203, 108, 111, for example, the flow paths 203, 108, 111 may be connected in series as one example. For example, the flow path 203 (supply piping 206A) and the flow path 108 could be connected by piping 107A and further the flow path 108 and the flow path 111 could be connected by piping 110B. Also, in the case of supplying refrigerant to the flow path 111, the refrigerant could be supplied from piping 110A connected to the flow path 111. For example, the refrigerant supplied to the flow path 111 is circulated to the flow path 108 and the refrigerant is further circulated from the flow path 108 to the flow path 203 of the interposer side.

By forming a structure in which the flow path formed in the interposer side is connected in series with the flow path (each of the plural flow paths laminated as necessary) formed in the semiconductor chip side and the refrigerant is circulated as described above, the structure (piping) in which the refrigerant is circulated can be formed in a simple construction.

In addition, in the semiconductor device 100B, 100C shown in Figs. 5 and 6, illustration of a supply part and a discharge part of the refrigerant of the flow paths 105, 108 formed in the semiconductor chip side is omitted, but the flow paths 105, 108 may be connected in series with the flow path 203 of the interposer side in a manner similar to the present embodiment. Also, a structure in which a refrigerant is separately supplied to each of the flow paths of the semiconductor chip side and the interposer side may be formed.

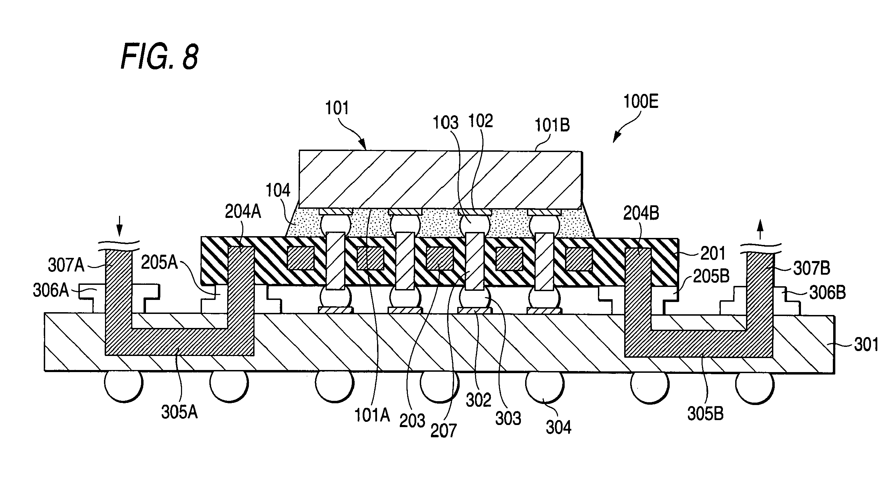

Also, Fig. 8 is a sectional diagram schematically showing a semiconductor device 100E according to a sixth embodiment of the invention. The semiconductor device 100E of the sixth embodiment differs from the semiconductor device 100A of the second embodiment in the following respect. Also, the portion which is not particularly described shall have a structure similar to that of the semiconductor device 100A shown in the second embodiment (Fig. 4).

Referring to Fig. 8, in the semiconductor device 100E according to the embodiment, flow paths (lower layer flow paths) 305A, 305B for circulating a refrigerant are formed in a substrate 301.

In the construction described above, a structure in which a flow path 203 formed in an interposer 201 is respectively connected in series with the flow paths 305A, 305B formed in the substrate 301 and the refrigerant is circulated may be formed.

For this purpose, for example, when a supply port 204A and a discharge port 204B (joint components 205A, 205B) formed in the interposer 201 are formed in the side facing the substrate 301, connection of the flow paths is facilitated and it is preferable. In this case, the flow path 203 is connected to the flow path 305A through the joint component 205A and the flow path 203 is connected to the flow path 305B through the joint component 205B, respectively.

Also, piping 307A for supplying a refrigerant to the flow path 305A is connected to a surface on which the interposer 201 of the substrate 301 is mounted (laminated) through a joint component 306A and similarly, piping 307B for discharging the refrigerant from the flow path 305B is connected to the surface through a joint component 306B.

In the semiconductor device 100E according to the embodiment, the substrate 301 together with the interposer 201 can be cooled by the refrigerant.

For example, the substrate 301 is cooled in addition to the interposer 201, the volume of the cooled portion increases and heat capacity of the cooled portion increases. As a result of this, for example, even though heat is suddenly generated in the semiconductor chip 101, speedy cooling can be performed. Further, a range of variations in temperature of the whole construction including the substrate 301 and the interposer 201 is decreased.

As a result of this, effects in which fears of failure or a break in wire due to expansion or warping of the substrate, the interposer or the semiconductor chip reduce and reliability of the semiconductor device improves are obtained.

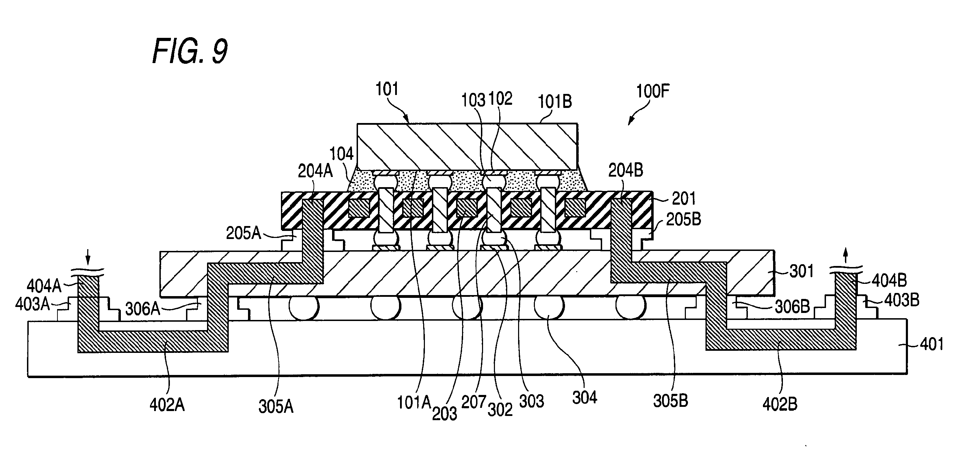

Also, Fig. 9 is a sectional diagram schematically showing a semiconductor device (motherboard) 100 F according to a seventh embodiment of the invention. The semiconductor device 100F of the seventh embodiment differs from the semiconductor device 100E of the sixth embodiment in the following respect. Also, the portion which is not particularly described shall have a structure similar to that of the semiconductor device 100E shown in the sixth embodiment (Fig. 8).

Referring to Fig. 9, in the semiconductor device 100F according to the embodiment, there is provided a board main body 401 on which a substrate 301 is mounted. Further, flow paths (bottom layer flow paths) 402A, 402B for circulating a refrigerant are formed in the board main body 401.

In the construction described above, a structure in which flow paths 305A, 305B formed in the substrate 301 are respectively connected in series with the flow paths 402A, 402B formed in the board main body 401 and a refrigerant is circulated may be formed.

For this purpose, for example, the flow path 305A formed in the substrate 301 is constructed so as to be connected to the flow path 402A formed in the board main body 401 through a joint component 306A. Similarly, the flow path 305B formed in the substrate 301 is constructed so as to be connected to the flow path 402B formed in the board main body 401 through a joint component 306B.

Also, piping 404A for supplying the refrigerant to the flow path 402A is connected to a surface on which the substrate 301 of the board main body 401 is mounted (laminated) through a joint component 403Aand similarly, piping 404B for discharging the refrigerant from the flow path 402B is connected to the surface through a joint component 403B.

In the semiconductor device (mother board) 100F according to the embodiment, the volume of the cooled portion increases more than the semiconductor device 100E according to the sixth embodiment (Fig. 8) and heat capacity of the cooled portion increases more. As a result of this, for example, even for sudden heat generation of a semiconductor chip 101, speedy cooling can be performed and also reliability of the semiconductor device improves more.

While heretofore the embodiment are described that the electronic circuit is formed on a side facing to the interposer, however the present invention does not limit to.

For an example, the electronic circuit may be formed on a side 101B of the semiconductor chip 101 opposite to the interposer 201. In this embodiment, although the cooling efficiency may be deteriorated with respect to the above described embodiments, since the electrode pad 102 connects the semiconductor chip 101 with the interposer 201, the cooling efficient is maintained high. Further, because the electronic circuit is formed on a top surface of the semiconductor chip 101, design freedom and manufacturing easiness are improved.

While heretofore the embodiments are described that a single layer semiconductor chip 101 is provided on the interposer 201, the present invention does not limit to. Since the cooling capacity is greatly enhanced, it becomes easy to mount a multilayer semiconductor chip having large calorific power on the interposer.

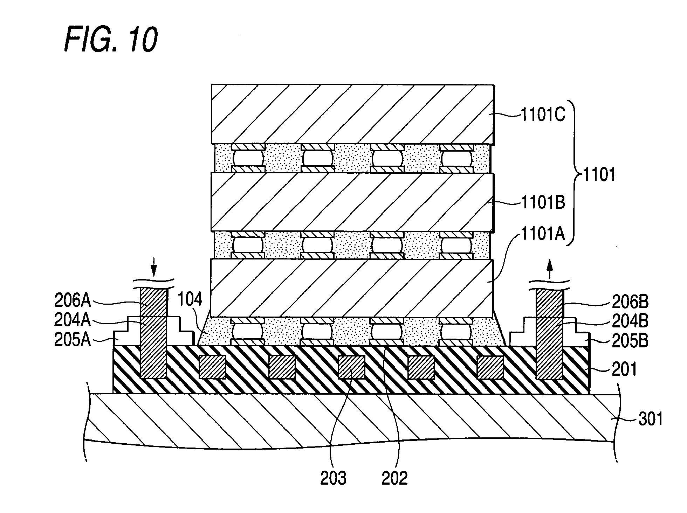

In Fig. 10, illustrated is an embodiment in which three semiconductor chips 1101A, 1101B, 1101C are laminated to form a multilayer semiconductor chip 1101. The multilayer semiconductor chip 1101 is provided on the interposer 201.

Due to the laminated structure, although the calorific power of the multilayer semiconductor 1101 is high and heat tends to concentrated therein, by employing the interposer having the flow path, the multilayer semiconductor can stably work owing to its large cooling capacity.

Although the explanation is done by using three semiconductor chips 1101A, 1101B, 1101C, the number of the semiconductor chips is not limited.

Further, the semiconductor chip may be designed so that the calorific power of the semiconductor chip is enough to vapor the refrigerant. Considering the pressure loss in the flow path, it is preferable to make the flow path short. Therefore, if the refrigerant is vapored underneath the semiconductor chip, it becomes possible to neglect the pressure loss in the downstream side of the flow path from the semiconductor chip. Thus, a pumping capacity of pump for supplying the refrigerant can be reduced.

The invention has been described above with reference to the preferred embodiments, but the invention is not limited to the specific embodiments described above, and various modifications and changes can be made within the gist described in the claims.

For example, a semiconductor chip mounted on the interposer 201 is not limited to one semiconductor chip, and plural semiconductor chips may be mounted on the interposer 201. For example, plural stacked semiconductor chips may be mounted on the interposer 201. Also, other semiconductor chips or electronic components (for example, a passive element) may be mounted on the interposer 201, the substrate 301 or the board main body 401.

According to the invention, cooling efficiency of a semiconductor device on which a semiconductor chip is provided can be improved.

## Claims

1. A semiconductor device comprising:
a semiconductor chip (101) on which an electrode pad (102) is formed; and
an interposer (201) to which the semiconductor chip is flip-chip bonded via the electrode pad,
wherein a flow path (203; 203A) for circulating refrigerant for cooling the semiconductor chip is formed in the interposer.

2. The semiconductor device as set forth in claim 1, wherein
a resin material (104) is inserted between the semiconductor chip and the interposer and
a filler made of a metallic material whose surface is covered with an insulating material is included in the resin material.

3. The semiconductor device as set forth in any of claims 1 to 2, further comprising
a penetrating electrode (207) extending through the interposer and connected to the electrode pad,
wherein the flow path is formed between the penetrating electrodes.

4. The semiconductor device as set forth in any of claims 1 to 3, wherein
an upper layer flow path (105; 108) is formed in or on the semiconductor chip at an opposite side of the interposer (201).

5. The semiconductor device as set forth in claim 4, wherein
the flow path (203) is connected in series with the upper layer flow path so that the refrigerant is circulated therein.

6. The semiconductor device as set forth in any of claims 1 to 5, further comprising:
a substrate (301) on which the interposer is provided,
wherein a lower layer flow path (305A, 305B) connected to the flow path is formed in the substrate (301) so that the refrigerant is circulated therein.

7. The semiconductor device as set forth in claim 6, wherein
a supply port (204A) for supplying the refrigerant to the flow path and a discharge port (204B) for discharging the refrigerant from the flow path are formed on the interposer (201) at a side facing to the substrate and
the supply port and the discharge port are respectively connected to the lower layer flow path.

8. The semiconductor device as set forth in any of claims 1 to 7, wherein
an electronic circuit is provided on a surface of the semiconductor chip at an opposite side of the interposer.

9. The semiconductor device as set forth in any of claims 1 to 7, wherein
an electronic circuit is provided on a surface of the semiconductor chip at a side facing to the interposer.

10. The semiconductor device as set forth in any of claims 1 to 9, wherein
pluralities of the semiconductor chips (101) laminated so as to form a multilayer are provided on the interposer via the electrode pad.

11. The semiconductor device as set forth in any of claims 1 to 10, wherein
the semiconductor chip is designed so that calorific power thereof is capable of vaporing the refrigerant in the flow path underneath the semiconductor chip.

12. A motherboard (100F) comprising:
a board main body (401); and
the semiconductor device as set forth in any of claims 6 to 11,
wherein the semiconductor device is mounted on the board main body, and
a bottom layer flow path connected to the lower layer flow path is formed in the board main body so that the refrigerant is circulated therein.
